# EUROPÄISCHE PATENTANMELDUNG

(11) **EP 2 942 632 A1**
(43) Veröffentlichungstag der Anmeldung: **11.11.2015**
(21) Anmeldenummer: 14167211.3
(22) Anmeldetag: 06.05.2014
(51) Int. Cl.: G01R 31/02, G01R 31/12, G01R 31/16

(54) **Erfassung von Teilentladungen**

(71) Anmelder: Siemens Aktiengesellschaft, 80333 München (DE)
(72) Erfinder: Coenen, Sebastian, 90451 Nürnberg (DE); Kutzner, Rüdiger, 90513 Zirndorf (DE)

(57) **Zusammenfassung**

Die Erfindung betrifft ein Verfahren zur Erfassung von Teilentladungen, die in einem Transformatorkessel eines Transformators stattfinden. Dabei werden aus dem Inneren des Transformatorkessels austretende elektromagnetische Wellen erfasst und ausgewertet. In Abhängigkeit von der Auswertung der elektromagnetischen Wellen wird auf eine Teilentladung als Ursache der elektromagnetischen Wellen geschlossen.

## Beschreibung

Die Erfindung betrifft ein Verfahren zur Erfassung von Teilentladungen, die in einem Transformatorkessel eines Transformators stattfinden.

Teilentladungen sind unerwünschte elektrische Entladungen, die an überbeanspruchten Stellen eines Isolationssystems entstehen. Ziel der Teilentladungsdiagnostik ist es, diese Fehlstellen zu detektieren und zu lokalisieren. Teilentladungsmessungen werden insbesondere zur Qualitätssicherung bei Abnahmeprüfungen und zunehmend zur Zustandsbewertung von gealterten Transformatoren durchgeführt. Die elektrische Teilentladungsmessung nach der Norm IEC 60270 (IEC = International Electrotechnical Commission) kann durch eine hohe Störanfälligkeit unter Umständen jede Diagnosesicherheit verlieren, wodurch insbesondere Teilentladungsmonitoring-Systeme an Aussagekraft verlieren.

Der Erfindung liegt die Aufgabe zugrunde, ein verbessertes Verfahren zur Erfassung von Teilentladungen, die in einem Transformatorkessel eines Transformators stattfinden, anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Bei dem erfindungsgemäßen Verfahren zur Erfassung von Teilentladungen, die in einem Transformatorkessel eines Transformators stattfinden, werden aus dem Inneren des Transformatorkessels austretende elektromagnetische Wellen erfasst und ausgewertet. In Abhängigkeit von der Auswertung der elektromagnetischen Wellen wird auf eine Teilentladung als Ursache der elektromagnetischen Wellen geschlossen.

Die Erfindung nutzt vorteilhaft die Tatsache, dass Teilentladungen hochfrequente Ausgleichströme hervorrufen, die elektromagnetische Wellen abstrahlen. Um diese Tatsache zur Erfassung von Teilentladungen, die in einem Transformatorkessel eines Transformators stattfinden, zu nutzen, ist erfindungsgemäß die Erfassung und Auswertung von aus dem Inneren des Transformatorkessels austretenden elektromagnetischen Wellen vorgesehen. Dadurch wird vorteilhaft vermieden, einen Sensor für die Erfassung elektromagnetischer Wellen in dem Inneren des Transformatorkessels anzuordnen.

Eine Ausgestaltung der Erfindung sieht vor, dass elektromagnetische Wellen erfasst und ausgewertet werden, die an wenigstens zwei verschiedenen Orten aus dem Inneren des Transformatorkessels austreten, wenigstens eine Laufzeitdifferenz dieser elektromagnetischen Wellen ermittelt wird, und aus der ermittelten wenigstens einen Laufzeitdifferenz auf einen Ort oder Bereich im Inneren des Transformatorkessels geschlossen wird, an dem die elektromagnetischen Wellen ausgesendet wurden.

Bei dieser Ausgestaltung der Erfindung wird durch die Erfassung und Auswertung der elektromagnetischen Wellen nicht nur auf Existenz von Teilentladungen innerhalb des Transformatorkessels geschlossen, sondern die Teilentladungen werden vorteilhaft auch lokalisiert, indem aus der Laufzeitdifferenz erfasster elektromagnetischer Wellen auf einen Ort oder Bereich der Entstehung der elektromagnetischen Wellen im Inneren des Transformatorkessels geschlossen wird.

Eine weitere Ausgestaltung der Erfindung sieht vor, dass elektromagnetische Wellen mit Frequenzen zwischen 0,3 GHz und 3 GHz erfasst und ausgewertet werden.

Diese Ausgestaltung der Erfindung nutzt vorteilhaft aus, dass Teilentladungen vornehmlich elektromagnetische Mikrowellen mit Wellenlängen im Dezimeterbereich, d. h. mit Frequenzen im so genannten UHF-Band (UHF = Ultra High Frequency) zwischen 0,3 GHz und 3 GHz erzeugen. Bei der vorgenannten Ausgestaltung der Erfindung wird die Erfassung und Auswertung elektromagnetischer Wellen also vorteilhaft auf einen für die Erfassung von Teilentladungen relevanten Frequenzbereich eingeschränkt und konzentriert.

Eine weitere Ausgestaltung der Erfindung sieht vor, dass die elektromagnetischen Wellen während eines Normalbetriebs des Transformators erfasst und ausgewertet werden.

Diese Ausgestaltung nutzt vorteilhaft aus, dass die erfindungsgemäße Erfassung von Teilentladungen keinen Eingriff in den Betrieb des Transformators erfordert und daher in dessen Normalbetrieb vorgenommen werden kann. Insbesondere braucht der Transformator zur erfindungsgemäßen Erfassung von Teilentladungen also nicht von mit ihm verbundenen Komponenten getrennt, vorübergehend außer Betrieb genommen oder in einen speziellen Betriebsmodus versetzt werden.

Eine weitere Ausgestaltung der Erfindung sieht vor, dass wenigstens eine Aufsatzeinheit mit wenigstens einer Durchführung an dem Transformatorkessel derart angeordnet wird, dass wenigstens eine Durchführung das Innere der Aufsatzeinheit mit dem Inneren des Transformatorkessels verbindet, und dass durch wenigstens eine derartige Durchführung aus dem Inneren des Transformatorkessels austretende elektromagnetische Wellen erfasst und ausgewertet werden.

Diese Ausgestaltung nutzt vorteilhaft Aufsatzeinheiten zur Auskopplung elektromagnetischer Wellen aus einem Transformatorkessel. Derartige Aufsatzeinheiten werden üblicherweise dazu benutzt, elektrische Signale z. B. von Stromwandlern aus dem Inneren eines Transformatorenkessels von außen messbar zu machen oder elektrische Beschaltungen wie Erdungen von außen zu beeinflussen oder messtechnisch nachzuweisen. Die vorgenannte Ausgestaltung nutzt also bekannte Aufsatzeinheiten auf völlig neuartige Weise, nämlich zur Erfassung von Teilentladungen. Insbesondere ermöglicht diese Ausgestaltung die Verwendung ohnehin bereits an Transformatorenkesseln angeordneter Aufsatzeinheiten zur Erfassung von Teilentladungen, so dass außer einem Mess- und Auswertesystem zur Erfassung und Auswertung elektromagnetischer Wellen keine zusätzlichen Komponenten zur Erfassung von Teilentladungen benötigt werden.

Eine weitere Ausgestaltung der Erfindung sieht vor, dass wenigstens ein durch eine Durchführung geführter elektrischer Leiter, beispielsweise eines im Transformatorenkessel angeordneten Stromwandlers, als eine Antennenstruktur zum Empfang im Inneren des Transformatorkessels erzeugter elektromagnetischer Wellen genutzt wird.

Diese Ausgestaltung ermöglicht vorteilhaft, bereits vorhandene elektrische Leiter als Antennenstruktur für den Empfang elektromagnetischer Wellen zu nutzen, so dass auch zusätzliche Sensoren für die Erfassung elektromagnetischer Wellen entfallen können.

Eine weitere Ausgestaltung der Erfindung sieht vor, dass die elektromagnetischen Wellen mittels eines Monitoringsystems ausgewertet werden.

Dadurch kann eine Teilentladungserfassung bequem und kontinuierlich während des Normalbetriebs des Transformators durchgeführt werden.

Die Erfindung sieht insbesondere vor, wenigstens ein Verbindungselement, das eine Außenseite eines Transformatorkessels mit dem Inneren des Transformatorkessels verbindet und für elektromagnetische Wellen durchlässig ist, zur erfindungsgemäßen Erfassung von Teilentladungen zu verwenden, wobei aus dem Inneren des Transformatorkessels durch das Verbindungselement austretende elektromagnetische Wellen erfasst und ausgewertet werden.

Diese Ausgestaltung der Erfindung ermöglicht vorteilhaft, ohnehin vorhandene Verbindungselemente, die zur Auskopplung elektromagnetischer Wellen aus dem Inneren des Transformatorkessels geeignet sind, zur erfindungsgemäßen Erfassung von Teilentladungen zu verwenden. Derartige Verbindungselemente sind beispielsweise oben bereits genannte Durchführungen von an dem Transformatorkessel angeordneten Aufsatzeinheiten.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine geschlossene Aufsatzeinheit in einer perspektivischen Darstellung, und
- FIG 2: eine Draufsicht auf eine geöffnete Aufsatzeinheit.

Einander entsprechende Teile sind in den Figuren mit den gleichen Bezugszeichen versehen.

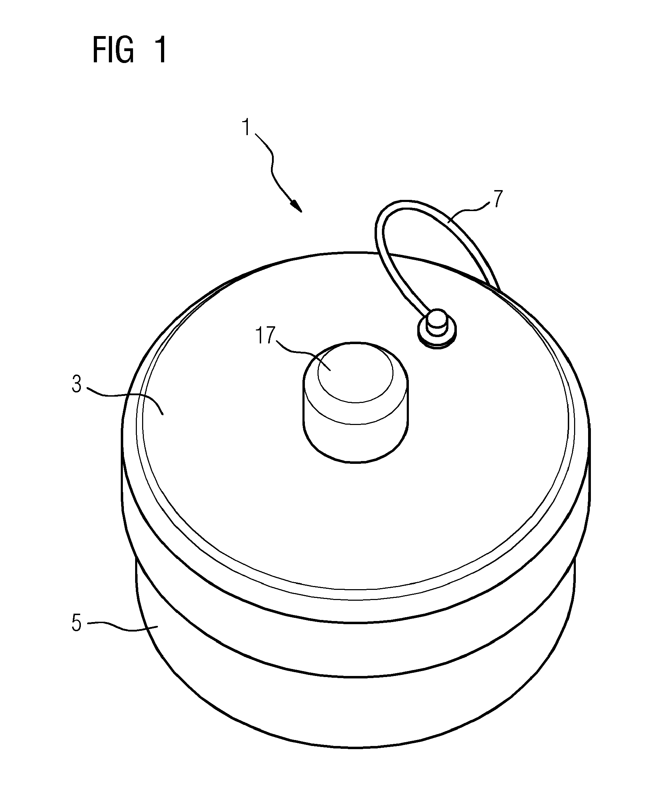

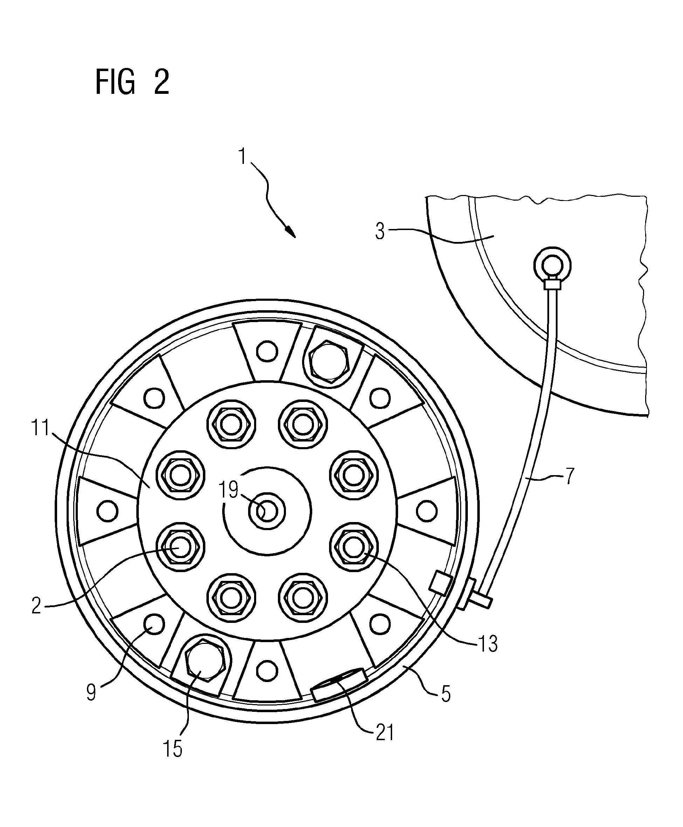

Figur 1 zeigt eine perspektivische Darstellung einer an sich wohlbekannten Aufsatzeinheit 1, die als ein Gehäuse für Durchführungen 2 (siehe Figur 2) ausgebildet ist. Die Aufsatzeinheit 1 umfasst einen Gehäusedeckel 3 und ein Gehäuseunterteil 5, das mit dem Gehäusedeckel 3 verschlossen wird und mit dem Gehäusedeckel 3 über ein Erdungskabel 7 verbindbar ist.

Figur 2 zeigt eine Draufsicht auf die in Figur 1 dargestellte Aufsatzeinheit 1 in einem geöffneten Zustand, in dem der Gehäusedeckel 3 von dem Gehäuseunterteil 5 getrennt ist. Das Gehäuseunterteil 5 weist acht als Niederspannungsdurchführungen ausgebildete Durchführungen 2 auf, die aus dem Inneren der Aufsatzeinheit 1 durch eine kreisringförmige Isolierstoffplatte 11 und den Boden des Gehäuseunterteil 5 hindurch geführt sind. Die Isolierstoffplatte 11 ist dabei beispielsweise als eine Gießharzplatte ausgebildet. Der Boden des Gehäuseunterteils 5 hat acht Löcher 9, die um die Isolierstoffplatte 11 herum angeordnet sind und zur Befestigung der Aufsatzeinheit 1 verwendet werden.

Die Durchführungen 2 sind im Inneren der Aufsatzeinheit 1 in Kontaktelementen 13 geführt, an denen elektrische Leitungen angeschlossen werden können. Ferner sind in dem Gehäuseunterteil 5 zwei Erdungskontakte 15 angeordnet, die durch den Gehäuseboden des Gehäuseunterteils 5 geführt sind und der Erdung der Aufsatzeinheit 1 dienen. Der Gehäusedeckel 3 wird an dem Gehäuseunterteil 5 mittels einer Verbindungsschraube 17 befestigt, die durch den Gehäusedeckel 3 geführt ist und in ein Gewinde 19 im Boden des Gehäuseunterteils 5 geschraubt wird. Das Gehäuseunterteil 5 weist ferner eine Wandöffnung 21 auf, durch die elektrische Leitungen geführt werden.

Ein erstes Ausführungsbeispiel der Erfindung sieht vor, dass eine Aufsatzeinheit 1 in einer zu der Aufsatzeinheit 1 korrespondierenden Aufnahme eines Transformatorkessels befestigt wird, so dass die Durchführungen 2 das Innere der Aufsatzeinheit 1 mit dem Inneren des Transformatorkessels verbinden. Aus dem Inneren des Transformatorkessels durch die Durchführungen 2 austretende elektromagnetische Wellen werden erfasst und ausgewertet, um Teilentladungen, die in dem Transformatorkessel stattfinden und elektromagnetische Wellen erzeugen, zu erfassen.

Ein weiteres Ausführungsbeispiel der Erfindung sieht vor, dass wenigstens zwei Aufsatzeinheiten 1 an demselben Transformatorkessel angeordnet werden und jeweils zur Erfassung von aus dem Inneren des Transformatorkessels durch ihre jeweiligen Durchführungen 2 austretenden elektromagnetischen Wellen genutzt werden. Dabei werden insbesondere Laufzeitdifferenzen der elektromagnetischen Wellen erfasst und ausgewertet und aus den Laufzeitdifferenzen werden die Orte oder Bereiche innerhalb des Transformatorenkessels ermittelt, in denen die elektromagnetischen Wellen jeweils erzeugt wurden, um in dem Transformatorenkessel stattfindende Teilentladungen zu lokalisieren.

In beiden Ausführungsbeispielen werden vorzugsweise elektromagnetische Wellen mit Frequenzen zwischen 0,3 GHz und 3 GHz erfasst und mittels eines Monitoringsystems ausgewertet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Erfassung von Teilentladungen, die in einem Transformatorkessel eines Transformators stattfinden, wobei
- aus dem Inneren des Transformatorkessels austretende elektromagnetische Wellen erfasst und ausgewertet werden,
- und in Abhängigkeit von der Auswertung der elektromagnetischen Wellen auf eine Teilentladung als Ursache der elektromagnetischen Wellen geschlossen wird.

2. Verfahren nach Anspruch 1,
**dadurch gekennzeichnet, dass** elektromagnetische Wellen erfasst und ausgewertet werden, die an wenigstens zwei verschiedenen Orten aus dem Inneren des Transformatorkessels austreten, wenigstens eine Laufzeitdifferenz dieser elektromagnetischen Wellen ermittelt wird, und aus der ermittelten wenigstens einen Laufzeitdifferenz auf einen Ort oder Bereich im Inneren des Transformatorkessels geschlossen wird, an dem die elektromagnetischen Wellen ausgesendet wurden.

3. Verfahren nach einem der vorhergehenden Ansprüche,
**dadurch gekennzeichnet, dass** elektromagnetische Wellen mit Frequenzen zwischen 0,3 GHz und 3 GHz erfasst und ausgewertet werden.

4. Verfahren nach einem der vorhergehenden Ansprüche,
**dadurch gekennzeichnet, dass** die elektromagnetischen Wellen während eines Normalbetriebs des Transformators erfasst und ausgewertet werden.

5. Verfahren nach einem der vorhergehenden Ansprüche,
**dadurch gekennzeichnet, dass** wenigstens eine Aufsatzeinheit (1) mit wenigstens einer Durchführungen (2) an dem Transformatorkessel derart angeordnet wird, dass wenigstens eine Durchführungen (2) das Innere der Aufsatzeinheit (1) mit dem Inneren des Transformatorkessels verbindet, und dass durch wenigstens eine derartige Durchführung (2) aus dem Inneren des Transformatorkessels austretende elektromagnetische Wellen erfasst und ausgewertet werden.

6. Verfahren nach Anspruch 5,
**dadurch gekennzeichnet, dass** wenigstens ein durch eine Durchführung (2) geführter elektrischer Leiter als eine Antennenstruktur zum Empfang im Inneren des Transformatorkessels erzeugter elektromagnetischer Wellen genutzt wird.

7. Verfahren nach einem der vorhergehenden Ansprüche,
**dadurch gekennzeichnet, dass** die elektromagnetischen Wellen mittels eines Monitoringsystems ausgewertet werden.

8. Verwendung wenigstens eines Verbindungselementes, das eine Außenseite eines Transformatorkessels mit dem Inneren des Transformatorkessels verbindet und für elektromagnetische Wellen durchlässig ist, zur Durchführung des Verfahrens nach einem der vorhergehenden Ansprüche, wobei aus dem Inneren des Transformatorkessels durch das Verbindungselement austretende elektromagnetische Wellen erfasst und ausgewertet werden.
